Europäisches Patentamt

European Patent Office

Office européen des brevets

(19)

(11) Veröffentlichungsnummer: **0 280 022**
**A1**

(12) **EUROPÄISCHE PATENTANMELDUNG**

(21) Anmeldenummer: **88100570.6**

(22) Anmeldetag: **16.01.88**

(51) Int. Cl.4: **H05K 3/34** , B23K 1/08

(30) Priorität: **28.01.87 CH 295/87**

(43) Veröffentlichungstag der Anmeldung:
**31.08.88 Patentblatt 88/35**

(84) Benannte Vertragsstaaten:
**BE CH DE FR GB IT LI NL SE**

(71) Anmelder: **EPM AG**
**Falkenweg 9**
**CH-6340 Baar(CH)**

(72) Erfinder: **Hess, Fritz**
**Erspachstrasse 26**
**CH-8932 Mettmenstetten(CH)**

(74) Vertreter: **Patentanwälte Schaad, Balass &**
**Partner**
**Dufourstrasse 101 Postfach**
**CH-8034 Zürich(CH)**

(54) **Verfahren und Anlage zum Löten von bestückten Leiterplatten.**

(57) Um die Lötung einer bestückten Leiterplatte
(13) ihrer Bestückungskonfiguration anzupassen,
wird die Leiterplatte (13) ein erstesmal in einer vorbestimmten Bahnkurve (57, 58) mit einer Lotwelle
(21) in Berührung gebracht, danach um eine vertikale Achse gedreht und ein zweitesmal in wiederum
vorbestimmten Bahnkurven aus derselben Richtung
mit vorzugsweise derselben Lotwelle (21) in
Berührung gebracht. Dabei kann die Leiterplatte
(13) während der Bewegung längs den Bahnkurven
(57, 58) einen von der Bestückungskonfiguration
abhängigen Winkel ($\alpha$), bezogen auf die Fliessrichtung (56) der Lotwelle (21), gedreht werden.

Fig.2

Fig.3

EP 0 280 022 A1

## Verfahren und Anlage zum Löten von bestückten Leiterplatten

Die Erfindung betrifft ein Verfahren gemäss dem Oberbegriff des Patentanspruches 1, sowie eine Anlage zur Durchführung des Verfahrens gemäss dem Oberbegriff des Patentanspruches 10.

Bei den immer kleiner werdenden Abmessungen der Schaltungselemente wird deren Anzahl pro Flächeneinheit der Leiterplatte immer grösser. Dementsprechend werden auch die Lötstellen immer kleiner. Die Bestückung von Leiterplatten, namentlich für die in sehr grossen Serien aufgelegten Geräte der Unterhaltungselektronik, Telekomunikation und Computerplatinen, erfolgt mit sehr hoher Präzision durch Bestückungsautomaten. Durch Lötung erfolgt dann die elektrische Verbindung zwischen den auf der Leiterplatte vorhandenen Leiterbahnen und den Anschlüssen der Schaltungselemente. Für die Operation des Lötens sind verschiedene Verfahren bekannt. Bei einem bekannten Verfahren der eingangs genannten Art wird die vorgewärmte Leiterplatte in der Regel längs eines geradlinig von der Horizontalen etwas ansteigenden Förderweges mit dem Scheitelbereich einer fliessenden Lotwelle oder auch von zwei Lotwellen in Berührung gebracht. Die Fliessrichtung der Lotwelle kann inbezug auf die Förderrichtung gleich oder gegensinnig sein. Bei zwei Lotwellen können deren Fliessrichtungen inbezug aufeinander gegensinnig sein. Dabei werden die bestückten Leiterplatten in der Regel in geführt verschiebbare Transportrahmen eingesetzt, deren Förderweg durch ein angetriebenes Fördermittel bestimmt wird. Diese Transportrahmen sind mit Einsätzen versehen, die ihrerseits mit durchgehenden Aussparungen versehen sind, deren Form den Umriss der zu lötenden Leiterplatte genau entspricht. Zum Betrieb einer Lötstrasse, das heisst einer Fertigungsstrasse, die unter anderem eine Station zum Auftragen von Flussmittel, eine Vorwärmstation und schliesslisch eine Wellenlöteinrichtung aufweist, ist eine Vielzahl von Transportrahmen mit den entsprechenden Einsätzen erforderlich. Da man bestrebt ist, in die in der Regel viereckigen Einsätze möglichst viele der ebenfalls in der Regel viereckigen Leiterplatten einzusetzen, sind zwei einander gegenüberliegende Seiten der Leiterplatten parallel zur Förderrichtung und damit zur Fliessrichtung der Lotwelle, wenn erstere in Berührung mit letzterer gelangt.

Nun hat sich aber gezeigt, dass die Güte der Verlötung einer Leiterplatte auch von der Konfiguration, das heisst von der "geographischen" Anordnung der Bestückung mit Schaltungselementen abhängig ist, namentlich dann, wenn die Leiterplatte auch auf der zu verlötenden Seite mit Bauteilen (Chips) bestückt ist. Diese Bestückungskonfiguration steht aber in keinerlei Zusammenhang mit dem Umriss der Leiterplatte, wenn man davon absieht, dass die Bestückung natürlich innerhalb dieses Umrisses zu sein hat.

Man hat daher bereits vorgeschlagen, die Ausnehmungen in den Einsätzen der Transportrahmen in einem solchen Winkel bezogen auf die Förderrichtung, zu orientieren, dass bei einer bestimmten Konfiguration der Bestückung eine optimale Lötung erreicht wird. Die Grösse der Winkelabweichung ist aber nur empirisch zu ermitteln, was voraussetzt, dass der optimale Winkel mit vielen, verschiedenen Einsätzen durch Versuche zu ermitteln ist, und dann alle vorhandenen Transportrahmen mit Einsätzen zu versehen sind, deren Ausnehmungen die optimale Winkelabweichung aufweisen.

Dabei wurde in Kauf genommen, dass der Raum innerhalb des Transportrahmens nicht bestmöglich, das heisst mit Einsätzen mit der theoretisch maximalen Anzahl von Ausnehmungen genützt wurde.

Dieses Vorgehen ist nicht nur sehr zeitraubend, sondern erfordert einen ganz erheblichen Aufwand an Versuchen, an Material und an Zeit zum Umrüsten einer Lötstrasse.

Ausserdem hat sich gezeigt, dass selbst bei Wellenlötmaschinen mit zwei gegenläufigen Lotwellen die Lötung nicht optimal ist, weil auch hier offenbar das Ergebnis stark von der Bestückungskonfiguration abhängt.

Ein Verfahren gemäss dem Oberbegriff des Patentanspruches 1 lässt sich als vorbekannt aus der DE-AI-3501376 herleiten. Hier sind zwei hintereinander angeordnete Lotwellen vorgesehen und die in herkömmlichen Einsätzen einer herkömmlichen Transporteinrichtung eingesetzten Leiterplatten werden längs einer geradlinigen Bahn nacheinander mit dem Scheitel der ersten und dann der zweiten Lotwelle in Berührung gebracht. Dabei sind die Lotwellen inbezug auf die Förderrichtung der Transporteinrichtung - schräggestellt, woraus sich ein spitzer Winkel zwischen zwei gegenüberliegenden Seiten der Leiterplatten und der Fliessrichtung der Lotwellen ergibt. Dieser spitze Winkel verlängert zwar die Wegstrecke entlang welcher die zu verlötende Seite der Leiterplatte vom Scheitel der Lotwelle "beleckt" wird; aber die zu verlötende Seite der Leiterplatten wird stets nur von der einen Seite her "beleckt", mit der Konsequenz, dass Lötstellen die auf ein abstehendes Schaltungselement (Chip) folgen, sich "im Schatten" dieses Schaltungselementes befinden, so dass die Lotwelle diese Lötstellen nicht erreicht.

Der Vollständigkeit halber sei es erwähnt, dass es auch bekannt ist, bestückte Leiterplatten ohne Transportrahmen zu verlöten. Zum einen geschieht dies mittels eines sogenannten "Fingertransports", bei dem die Leiterplatten an gegenüberliegenden Rändern durch gesteuerte Klemmfinger mit Widerhaken erfasst werden, wobei die Klemmfinger auf der einen und auf der anderen Seite des Förderweges an je einem endlosen, umlaufend angetriebenen und geführten Förderorgan befestigt sind. Damit erübrigt sich zwar der Einsatz vom Transportrahmen, aber ein Fingertransport ist jeweils nur für ein Format von Leiterplatten konzipiert und diese werden parallel zu einer ihrer Seiten über die Lotwelle geführt. Abgesehen davon, besteht in diesem Fall die Gefahr, dass sich die Leiterplatten beim Vorwärmen und Löten durchbiegen.

.Ein weiteres Lötverfahren ohne (oder auch mit) Transportrahmen wird in Fachkreisen als "Reflow-löten" bezeichnet. Dabei wird die noch unbestückte Leiterplatte mit einem Siebdruckverfahren nur an den vorgesehenen Lötstellen mit einer lot-und flussmittelhaltigen Paste bedruckt, wonach die Leiterplatte in einem Bestückungsautomaten bestückt und nach der Bestückung beispielsweise durch IR-Strahlung erwärmt werden, so dass das Lot in der Paste - schmilzt und die Lotverbindung der Anschlüsse der Bauelemente mit den Leiterbahnen erreicht wird. Das "Reflow-löten" hat indessen in der Praxis kaum Eingang gefunden, wohl unter anderem deswegen, weil ausserordentlich hohe Präzision und Uebereinstimmung sowohl beim Bedrucken als auch beim Bestücken zwingend notwendig sind.

Es ist daher ein Zweck der Erfindung, ein Verfahren und eine Anlage der eingangs genannten Art vorzuschlagen, welche die erwähnten Nachteile des Standes der Technik weitgehend vermeiden und auch für kleinere Serien optimale Lötverbindungen gewährleisten, ohne dass zuvor mit entsprechendem Aufwand grosse Versuchsreihen durchgeführt werden müssten.

Dieser Zweck wird beim Verfahren dadurch erreicht, dass es die im Kennzeichen des Patentanspruches 1 umschriebenen Schritte umfasst. Dadurch, dass nach der ersten Berührung der Lotwelle die Leiterplatte um die vertikal stehende Achse, vor der zweiten Lötung mit der Lotwelle, gedreht wird, wird die zu lötende Seite der Leiterplatte aus zwei verschiedenen Richtungen von der Lotwelle beziehungsweise den Lotwellen "beleckt, wobei diese zwei Richtungen optimal der Bestückungskonfiguration angepasst werden können.

Merkmale bevorzugter Ausführungsformen des Verfahrens sind den abhängigen Ansprüchen 2 bis 9 zu entnehmen, während die zur Durchführung des Verfahrens vorgeschlagene Anlage im Patentanspruch 10 definiert ist.

Weitere Vorteile ergeben sich aus der nachfolgenden rein beispielsweisen Beschreibung anhand der Zeichnung.

Es zeigt:

Fig. 1 eine perspektivische Ansicht einer Anlage zur Durchführung des Verfahrens,

Fig. 2 eine sehr schematische Seitenansicht einer Lotwelle mit dem Verlauf von zwei möglichen Bahnkurven, entlang welchen die Leiterplatte ein erstes Mal mit der Lotwelle in Berührung gebracht wird,

Fig. 3 eine Draufsicht auf Fig. 2 mit der - schematischen Darstellung einer Leiterplatte (Bestückung weggelassen),

Fig. 4 in ähnlicher Darstellung wie Fig. 2 mit dem Verlauf von zwei möglichen Bahnkurven, entlang welchen die Leiterplatte ein zweites Mal mit der Lotwelle in Berührung gebracht wird, und

Fig. 5 eine Draufsicht auf Fig. 4.

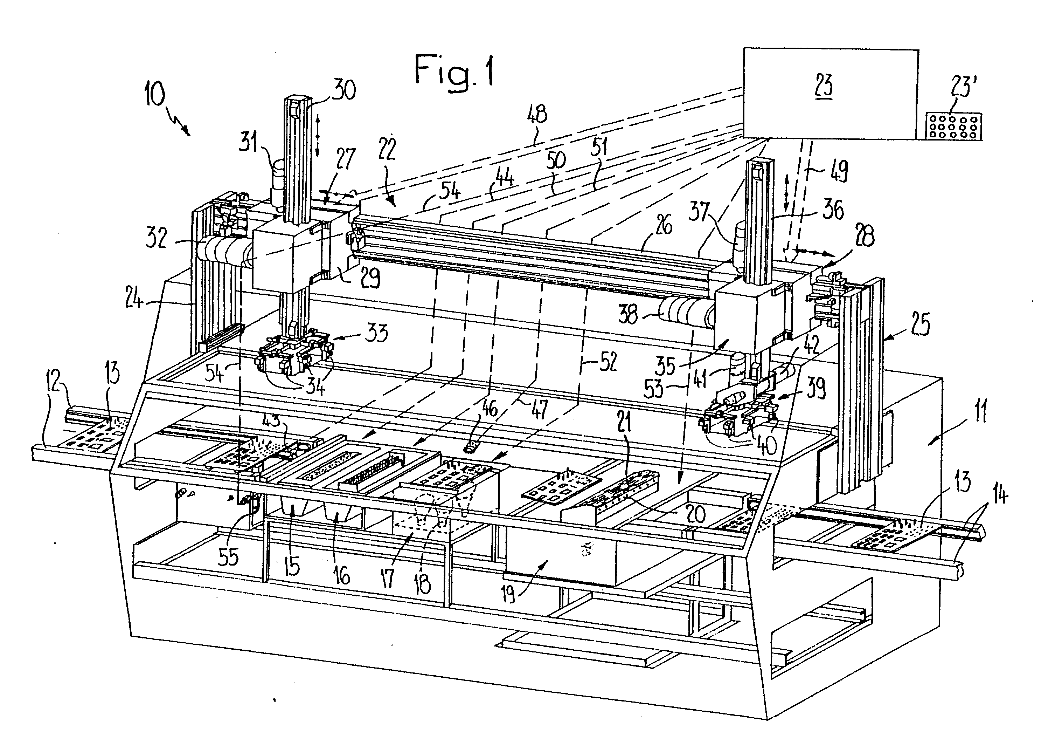

Bei der in Fig. 1 dargestellten Anlage 10 besteht der untere Teil im wesentlichen aus einer herkömmlichen Lötstrasse 11, der von einem Zuförderer 12 bestückte Leiterplatte 13 zugeführt werden, welche, nach dem Lötprozess von einem Ausförderer 14 abtransportiert werden.

Die Lötstrasse 11 weist folgende Stationen auf: Zwei Flussmittel-Auftragstationen (sogenannte "Fluxer") 15, 16 an denen je nach zur Anwendung gelangenden Flussmitteln die Unterseite der Leiterplatte 13 mit Flussmittel versehen werden. Beispielsweise ist der Fluxer 15 ein Schaumfluxer, in dem die Unterseite der Leiterplatte 13 in Berührung mit einer Welle aus einem feinporigen Flussmittelschaum gebracht wird und der Fluxer 16 ist ein Sprüh-Fluxer, bei dem das Flussmittel in einem Sprühstrahl zerstäubt aufgetragen wird. Auf die Fluxer 15, 16 folgt eine Vorwärmstation 17 in der mittels IR-Lampen 18 die Unterseite der Leiterplatten 13 vorgewärmt wird. Auf die Vorwärmstation 17 folgt eine herkömmliche Wellenlöteinrichtung 19, welche aus einer Lotschmelze mittels einer Pumpe (beides nicht dargestellt) über eine Schlitzdüse 20 eine kontinuierlich fliessende Lotwelle 21 erzeugt. Soweit die Kurzbeschreibung der an sich bekannten Lötstrasse 11 für bestückte Leiterplatten.

Der Transport der Leiterplatten 13 vom Zuförderer 12 über die Lötstrasse 11 bis zum Ausförderer 14 wird von einer allgemein mit der Bezugsziffer 22 bezeichneten Transporteinrichtung besorgt, die von einem nur schematisch angedeuteten Rechner 23 gesteuert ist.

Die Transporteinrichtung weist eine auf Stützposten 24, 25 abgestützte, die Lötstrasse 11 portalartig überspannende und parallel zu dieser verlaufende, horizontale Führungsschiene 26 auf, längs welcher zwei mit Eigenantrieb versehene Robotereinheiten 27, 28 verschiebbar sind. Die Robotereinheit 27 weist einen verschiebbar auf der Führungsschiene gelagerten Antriebskasten 29 auf, in welchem eine Hubstange 30 vertikal verschiebbar gelagert ist. Am Antriebskasten 29 sind zwei vom Rechner 23 aus gesteuerte Motoren 31, 32 angeflanscht, von denen der eine den Antrieb zur Horizontalbewegung des Antriebskastens 29 längs der Führungsschiene 26, und der andere den Antrieb zur Vertikalbewegung der Hubstange 30 liefert. An ihrem unteren Ende trägt die Hubstange 30 einen Greiferkopf 33, der mit insgesamt acht elektromagnetisch oder pneumatisch gesteuert betätigbaren Greifern 34 versehen ist, die dazu bestimmt sind, jeweils paarweise eine Leiterplatte an deren vier Seiten festzuhalten.

Die Robotereinheit 28 weist ebenfalls einen Antriebskasten 35 auf, der verschiebbar auf der Führungsschiene 26 gelagert ist. Im Antriebskasten 35 ist eine Hubstange 34 vertikal verschiebbar gelagert. Mit 37 und 38 sind am Antriebskasten 35 angeflanschte und vom Rechner 23 angesteuerte Motoren bezeichnet, von denen der eine den Antrieb für die Horizontalbewegung des Antriebskastens 35, der andere dagegen den Antrieb für die Vertikalbewegung der Hubstange 36 liefert. An ihrem unteren Ende trägt die Hubstange 36 einen Greiferkopf 39, der nicht nur (ähnlich wie der Greiferkopf 33) mit insgesamt acht pneumatisch oder elektromagnetisch betätigbaren Greifern 40 versehen ist, sondern auch als Ganzes mittels eines Motores 41 um eine zur Längsrichtung der Hubstange parallele Vertikalachse und mittels eines weiteren Motors 42 um eine zur Längsrichtung der Führungsschiene 26 rechtwinklige Horizontalachse drehbar bzw. schwenkbar ist.

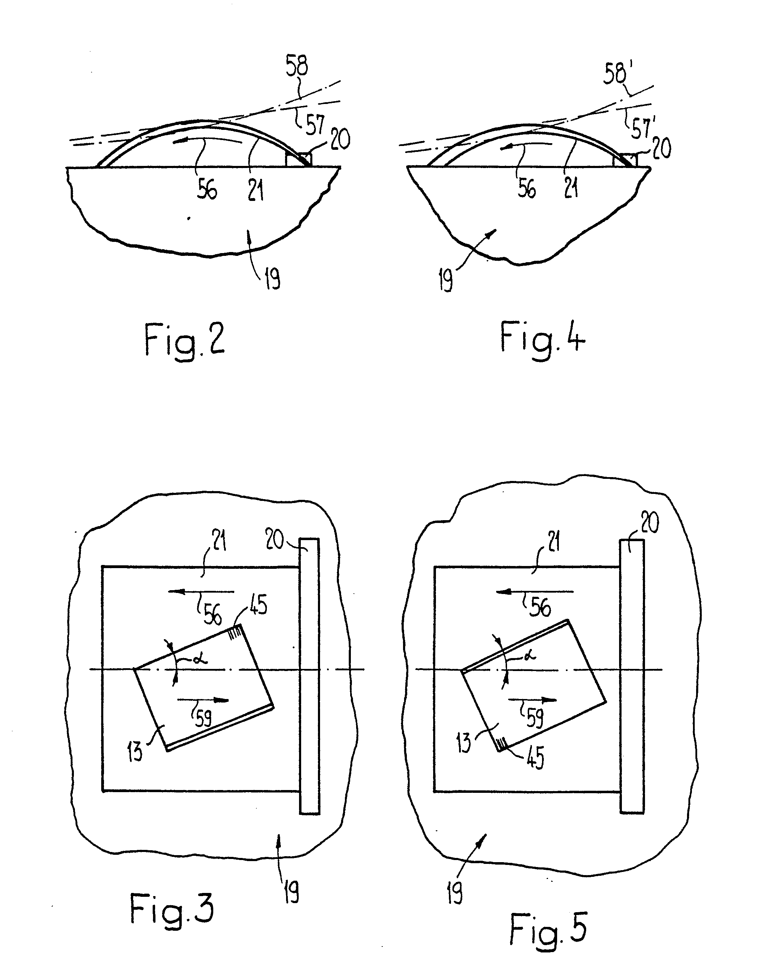

Im Abgabebereich des Zuförderers 12 ist ein Sensor 43 angeordnet, der über eine Datenleitung 44 an den Rechner angeschlossen ist. Dieser Sensor 43 ist nicht nur dazu ingerichtet, die Ankunft einer bestückten Leiterplatte 13 am Ende des Zuförderers 12 festzustellen, sondern auch eine auf dieser Leiterplatte angebrachte, maschinenlesbare Codemarkierung 45 (Fig. 3, 5) zu lesen und die entsprechenden Daten dem Rechner 23 zuzuführen. Auf den Sinn dieser Codemarkierung 45 wird in der weiteren Beschreibung näher eingegangen.

Im Bereich der Vorwärmstation 17 ist ein Temperaturfühler 46, beispielsweise ein IR-Messkopf, auf die sich gerade auf der Vorwärmstation 17 befindliche Leiterplatte 13 gerichtet und über eine Datenleitung 47 an den Rechner 23 angeschlossen. Ueber einen Leitungsstrang 48 steuert der Rechner 23 gemäss einem bestimmten Programm alle Betätigungselemente der Robotereinheit 27 und über einen weiteren Leitungsstrang 49 alle Betätigungselemente der Robotereinheit 28 nach einem anderen Programm.

Ueber Steuerleitungen 50, 51, werden vom Rechner 23 aus die Fluxer 15 bzw. 16 ein-oder ausgeschaltet, und über eine Steuerleitung 52 die IR-Lampen 18 der Vorwärmstation 17 ein-bzw. ausgeschaltet. Schliesslich steuert der Rechner über eine Steuerleitung 53 auch den Betrieb der Wellenlöteinrichtung 19.

Die noch folgende Beschreibung der Arbeitsweise der in Fig. 1 dargestellten Anlage dient auch dazu, dem Fachmann Hinweise für jene Elemente der Anlage 10 zu geben, die hier nicht ausdrücklich beschrieben und/oder dargestellt sind, die jedoch für die Arbeitsweise der Anlage erforderlich sind.

Der Sensor 43 am Ende des Zuförderers 12 meldet dem Rechner 23 über die Datenleitung 44 die Anwesenheit einer zu lötenden Leiterplatte 13 und übermittelt dem Rechner auch die von der Codemarkierung 45 abgelesenen Daten. Der Rechner 23 betätigt sodann über eine Steuerleitung 54 ein pneumatisches oder magnetisches Hubelement 55 am Ende des Zuförderers 12, welches die Leiterplatte vom Zuförderer 12 anhebt. Gleichzeitig "beordert" der Rechner 23 die Robotereinheit 27 in die in Fig. 1 links erscheinende Endstellung, senkt deren Greiferkopf 33 bei offenen Greifern 34 ab und erfasst die bereitliegende Leiterplatte 13. Danach wird der Greiferkopf 33 etwas angehoben und die Robotereinheit 27 im Schnellgang, mit einer Geschwindigkeit von beispielsweise 6 m/s, unter Rückmeldung der Position an den Rechner 23, in Richtung zu den Fluxern 15, 16 bewegt. Je nach gewünschter Auftragungsart aktiviert der Rechner 23 den einen oder anderen Fluxer 15, 16 und reduziert die Geschwindigkeit der Robotereinheit 27 auf beispielsweise 1 m/s, sobald diese den aktivierten Fluxer erreicht. Nach dem Flussmittelauftrag in dem aktivierten Fluxer wird die Robotereinheit 27 im Schnellgang zu der Vorwärmstation 17 verschoben, der Greiferkopf 33 abgesenkt und die Greifer 34 werden geöffnet. Damit ist die Leiterplatte auf der Vorwärmstation 17 abgelegt, deren IR-Lampen 18 gleichzeitig eingeschaltet werden. Der Greiferkopf 33 wird nun angehoben und die ganze Robotereinheit 27 fährt im Schnell gang zurück in den Endbereich des Zuförderers 12.

Der Temperaturfühler 46 misst kontinuierlich die Temperatur der auf der Vorwärmstation 17 befindlichen Leiterplatte und übermittelt Temperaturdaten dem Rechner 23. Sobald ein im Rechner 23 gespeicherten Temperaturwert erreicht ist, tritt die Robotereinheit 28 in Aktion, deren Greiferkopf 39 die vorgewärmte Leiterplatte aufnimmt, diese um einen Winkel α (Fig. 3) horizontal dreht und längs einer vom Rechner 23 bestimmten Bahnkurve mit einer ebenfalls vom Rechner 23 bestimmten Geschwindigkeit (beispielsweise zwischen 0,5 und 3 m/s) ein erstes Mal zu der Lotwelle 21 zum

7    0 280 022    8

Lötvorgang bringt.

In den Fig. 2-5 ist mit dem Pfeil 56 die Fliessrichtung der Lotwelle 21 angegeben. Mit einer gestrichelten Linie 57 ist in Fig. 2 eine geradlinig ansteigende und mit der strichpunktierten Linie 58 eine gekrümmte, von der horizontalen zunehmend ansteigende Bahnkurve angedeutet, die die vom Greiferkopf 39 gehaltene Leiterplatte während des ersten Lötvorganges in der Lotwelle 21 in Richtung des Pfeiles 59 beschreibt.

Nach diesem ersten Lötvorgang wird der Greiferkopf 39 angehoben, die Robotereinheit 28 im Schnellgang zurückgefahren und der Greiferkopf 39 gleichzeitig horizontal um einen Winkel (in diesem Beispiel 180°) gedreht wieder abgesenkt und längs einer der Bahnkurven 57', 58' (Fig. 4) wird die Leiterplatte ein zweites Mal mit der Lotwelle 21 in Berührung gebracht.

Danach wird der Greiferkopf 39 angehoben und die Robotereinheit 28 im Schnellgang über den Anfangsbereich des Ausförderers 14 verschoben, der Greiferkopf 39 abgesenkt, worauf die Leiterplatte 13 durch Oeffnen der Greifer 40 auf den Ausförderer 14 gelangt und von diesem abtransportiert wird.

Im beschriebenen Beispiel wird die Leiterplatte nach dem ersten Lötvorgang in der Lötwelle im 180° gedreht, so dass der Drehwinkel $\alpha$ für beide Durchgänge gleich ist. Sowohl der Drehwinkel für den ersten Durchgang, als auch der Drehwinkel nach dem ersten und vor dem zweiten Durchgang wie die bei beiden Durchgängen zu beschreibenden Bahnkurven und die entsprechenden Geschwindigkeiten sind dank der numerischen Steuerung aller Bewegungen durch den Rechner 23 optimal an die Bestückungskonfiguration der jeweiligen Leiterplatte anpassbar, wobei nur wenige Versuche erforderlich sind, um alle diese Parameter von Fall zu Fall zu bestimmen. Diese Parameter lassen sich beispielsweise mit einem Strichcode darstellen, und, wenn jede zu lötende Leiterplatte mit einer solchen Codemarkierung versehen wird, welche die für sie geeigneten Parameter darstellt, dann ist die beschriebene Anlage in der Lage, praktisch ohne Umrüstung, hintereinander unterschiedlich bestückte Leiterplatten zu löten. Für Versuche können dem Rechner 23 die genannten Parameter auch über eine Tastatur 23' eingegeben werden.

An sich ist das Verfahren auch mit einer sogenannten "2-Wellen-Lötstrasse" durchführbar. Dabei wird die Leiterplatte nach dem ersten Lötvorgang an der ersten Welle um die vertikale Achse gedreht, z.B. um 180° und erst dann dem Lötvorgang an der zweiten Welle zugeführt.

**Ansprüche**

1. Verfahren zum Löten von bestückten Leiterplatten, bei dem jede Leiterplatte (13) an der zur Lötung vorgesehenen und mit einem Flussmittel versehenen Lötseite vorgewärmt wird und in warmen Zustand entlang einer Bahnkurve (57, 58) auf dieser Seite zweimal mit einer fliessenden Lotwelle (21) in Berührung gebracht wird, wobei zwei gegenüberliegende Seitenkanten der Leiterplatte (13) einen spitzen Winkel ($\alpha$) mit der Fliessrichtung (56) der Lotwelle (21) einschliessen, durch gekennzeichnet, dass nach dem ersten Lötvorgang die Leiterplatte (13) um eine vertikal stehende Achse gedreht wird und entlang einer weiteren Bahnkurve (57', 58') zum zweiten Lötvorgang gebracht wird.

2. Verfahren nach Patentanspruch 1, dadurch gekennzeichnet, dass die Leiterplatte (13) zum ersten und zum zweiten Lötvorgang mit ein-und derselben Lotwelle (21) in Berührung gebracht wird.

3. Verfahren nach Patentanspruch 2, dadurch gekennzeichnet, dass die Leiterplatte (13) beide Male von derselben Seite her mit der Lotwelle (21) in Berührung gebracht wird.

4. Verfahren nach einem der Patentansprüche 1 bis 3, dadurch gekennzeichnet, dass nach dem ersten Lötvorgang an der Lotwelle (21) die Leiterplatte um im wesentlichen 180° gedreht wird.

5. Verfahren nach einem der Patentansprüche 1 bis 4, dadurch gekennzeichnet, dass beide Bahnkurven (57, 58; 57', 58') numerisch gesteuert werden.

6. Verfahren nach einem der Patentansprüche 1 bis 5, dadurch gekennzeichnet, dass die Leiterplatte (13) zumindest im Bereich der einen Lotwelle (21) entlang einer von der Horizontalen zunehmend ansteigenden Bahnkurve (58, 58') bewegt wird.

7. Verfahren nach einem der Patentansprüche 1 bis 6, dadurch gekennzeichent, dass beim Vorwärmen der Leiterplatte (13) deren Temperatur abgetastet wird und beim Erreichen eines vorbestimmten Temperaturwertes die Leiterplatte einzeln aufgenommen und entlang der Bahnkurve (57, 58) mit der Lotwelle (21) in Berührung gebracht wird.

8. Verfahren nach einem der Patentansprüche 1 bis 7, dadurch gekennzeichent, dass die beiden Bahnkurven (57, 57'; 58, 58') mindestens annährend die gleiche Form haben.

9. Verfahren nach Patentanspruch 7, dadurch gekennzeichnet, dass die Leiterplatte (13) mit einer maschinenlesbaren Codemarkierung (45) versehen wird, die einerseits die Bahnkurven (57, 57'; 58, 58') und andererseits den spitzen Winkel ($\alpha$) der gegenüberliegenden Seitenkanten der Leiterplatte (13) bezogen auf die Fliessrichtung (56) der Lotwelle (21) bestimmt.

5

10. Anlage zur Durchführung des Verfahrens nach Patentanspruch 1, mit einer Vorwärmstation (17) und einer dieser nachfolgend angeordneten Wellenlöteinrichtung (19), sowie mit Transportmitteln (22) um Leiterplatten (13) von der Vorwärmstation (17) über die Wellenlöteinrichtung (19) zu einem Ausförderer (14) zu transportieren, dadurch gekennzeichnet, dass die Transportmittel (22) einen, in mindestens zwei Koordinatenrichtungen verschiebbaren und um zumindest eine zu einer dieser Koordinatenrichtungen parallele Achse verdrehbaren Greiferkopf (39) aufweisen, der in seinen Bewegungen von einem Rechner (23) gesteuert und dazu eingerichtet ist, jeweils eine Leiterplatte (13) von der Vorwärmstation (17) aufzunehmen und diese entlang einer durch den Rechner vorbestimmten Bahnkurve (57, 58; 57', 58') mit Ihrer Lötseite zweimal mit einer Lotwelle (21) der Wellenlöteinrichtung (19) in Berührung zu bringen.

11. Anlage nach Patentanspruch 10, bei der der Vorwärmstation (17) ein die Temperatur einer in dieser Station befindlichen Leiterplatte (13) zu messen bestimmter Temperaturfühler (46) angeordnet ist, der an den Rechner (23) angeschlossen ist, dadurch gekennzeichnet dass der Rechner (23) dazu eingerichtet ist, den Greiferkopf (39) in Bewegung zu setzen, wenn die Temperatur der Leiterplatte (13) einen vorbestimmten Wert erreicht hat.

12. Anlage nach Patentanspruch 10 oder 11, zur Durchführung des Verfahrens gemäss Patentanspruch 9, mit einem, die zu lötenden Leiterplatten (13) liefernden, Zuförderer (12), dadurch gekennzeichent, dass im Endbereich des Zuförderers (12) ein an den Rechner (23) angeschlossener Sensor (43) angeordnet ist, der dazu eingerichtet ist, das Vorhandensein einer Leiterplatte (13) festzustellen und gegebenenfalls die auf der Leiterplatte (13) angebrachte Codemarkierung (45) zu lesen.

Fig.1

Fig.2

Fig.4

Fig.3

Fig.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 203 623 (ITALTEL SOCIETA ITALIANA TELECOMUNICAZIONI) * Seite 9, Zeilen 5-25; Figuren 2,5 * --- | 1,3 | H 05 K 3/34 B 23 K 1/08 |
| A | EP-A-0 118 091 (ELECTROVERT LTD) * Seite 5, Absatz 3 - Seite 7, Absatz 2 * --- | 1,7,10, 11 | |
| A,D | DE-A-3 501 376 (PHILIPS PATENT VERWALTUNG GmbH) * Seite 5, Zeile 6 - Seite 6, Zeile 26; Seite 7, Zeile 1 - Seite 8, Zeile 25 * ----- | 1,3 | |

| RECHERCHIERTE SACHGEBIETE (Int. Cl.4) |
|---|
| H 05 K B 23 K |

Der vorliegende Recherchenbericht wurde für alle Patentansprüche erstellt

| Recherchenort | Abschlußdatum der Recherche | Prüfer |
|---|---|---|
| DEN HAAG | 03-05-1988 | SCHUERMANS N.F.G. |

EPO FORM 1503 03.82 (P0403)